(19) Europäisches Patentamt
European Patent Office
Office européen des brevets

(11) **EP 2 401 624 B1**

(12) **FASCICULE DE BREVET EUROPEEN**

(45) Date de publication et mention de la délivrance du brevet:
**26.05.2021 Bulletin 2021/21**

(51) Int Cl.:
*G01R 31/392* (2019.01)　*H01M 8/04664* (2016.01)

(21) Numéro de dépôt: **10704377.0**

(22) Date de dépôt: **22.02.2010**

(86) Numéro de dépôt international:
**PCT/EP2010/052176**

(87) Numéro de publication internationale:
**WO 2010/097355 (02.09.2010 Gazette 2010/35)**

(54) **PROCEDE DE DETERMINATION D'UN ETAT DE SANTE D'UN DISPOSITIF ELECTROCHIMIQUE**

VERFAHREN ZUM BESTIMMEN EINES GESUNDHEITSZUSTANDS EINER ELEKTROCHEMISCHEN EINRICHTUNG

METHOD OF DETERMINING A STATE OF HEALTH OF AN ELECTROCHEMICAL DEVICE

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **24.02.2009 FR 0951168**

(43) Date de publication de la demande:
**04.01.2012 Bulletin 2012/01**

(73) Titulaires:
- **Helion**
**13545 Aix en Provence Cedex 4 (FR)**
- **Institut National Polytechnique de Toulouse**
**31029 Toulouse Cedex 4 (FR)**
- **Centre National de la Recherche Scientifique**
**75016 Paris (FR)**

(72) Inventeurs:
- **PHLIPPOTEAU, Vincent**
**13545 Aix en Provence cedex 4 (FR)**
- **RAKOTONDRAINIBE, André**
**F-13045 Aix-en-Provence (FR)**
- **TURPIN, Christophe**
**F-31100 Toulouse (FR)**
- **FONTES, Guillaume**
**F-31000 Toulouse (FR)**

(74) Mandataire: **Ilgart, Jean-Christophe et al BREVALEX**
**95, rue d'Amsterdam**
**75378 Paris Cedex 8 (FR)**

(56) Documents cités:
**EP-A1- 1 923 945　WO-A2-03/098769**

US-A1- 2003 204 328　US-A1- 2006 078 788
US-A1- 2006 170 397　US-A1- 2006 284 600
US-A1- 2007 132 456　US-A1- 2008 091 367
US-B1- 6 456 988

- **G. Fontès: "Modélisation et caractérisation de la pile PEM pour l'étude des interactions avec les convertisseurs statiques" 16 septembre 2005 (2005-09-16), , Toulouse , XP002581575 , pages 1,75-109 cité dans la demande alinéa [3.3.1] - alinéa [3.3.2] alinéa [3.4.1.2] alinéa [3.4.2]**
- **ANDREAUS B ET AL: "Proton-conducting polymer membranes in fuel cells-humidification aspects" SOLID STATE IONICS, NORTH HOLLAND PUB. COMPANY. AMSTERDAM; NL, NL LNKD- DOI:10.1016/J.SSI.2003.01.001, vol. 168, no. 3-4, 31 mars 2004 (2004-03-31), pages 311-320, XP004507529 ISSN: 0167-2738**
- **YUAN ET AL: "AC impedance technique in PEM fuel cell diagnosis-A review" INTERNATIONAL JOURNAL OF HYDROGEN ENERGY, ELSEVIER SCIENCE PUBLISHERS B.V., BARKING, GB LNKD- DOI:10.1016/J.IJHYDENE.2007.05.036, vol. 32, no. 17, 29 novembre 2007 (2007-11-29), pages 4365-4380, XP022369437 ISSN: 0360-3199**
- **FOUQUET N ET AL: "Model based PEM fuel cell state-of-health monitoring via ac impedance measurements" JOURNAL OF POWER SOURCES, ELSEVIER SA, CH, vol. 159, no. 2, 22 septembre 2006 (2006-09-22), pages 905-913, XP025084267 ISSN: 0378-7753 [extrait le 2006-09-22]**

- CHO J ET AL: "Transient response of a unit proton-exchange membrane fuel cell under various operating conditions" JOURNAL OF POWER SOURCES, ELSEVIER SA, CH, vol. 185, no. 1, 15 octobre 2008 (2008-10-15), pages 118-128, XP025399270 ISSN: 0378-7753 [extrait le 2008-07-06]
- DANZER M A ET AL: "Electrochemical parameter identification-An efficient method for fuel cell impedance characterisation", JOURNAL OF POWER SOURCES, ELSEVIER SA, CH, vol. 183, no. 1, 15 August 2008 (2008-08-15), pages 55-61, XP022832938, ISSN: 0378-7753, DOI: 10.1016/J.JPOWSOUR.2008.04.071 [retrieved on 2008-05-04]
- FONTES GUILLAUME: "MODELISATION ET CARACTERISATION DE LA PILE PEM POUR L'ETUDE DES INTERACTIONS AVEC LES CONVERTISSEURS STATIQUES", THESIS,, 3 June 2006 (2006-06-03), page 219pp, XP007912986,

**Description**

## DESCRIPTION

### DOMAINE TECHNIQUE

La présente invention se rapporte au domaine général des dispositifs électrochimiques, et concerne plus spécialement un procédé de détermination, ou de diagnostic, d'un état de santé dudit dispositif électrochimique.
Le dispositif électrochimique peut être une pile à combustible ou un électrolyseur.

### ETAT DE LA TECHNIQUE ANTERIEURE

D'une manière générale, un dispositif électrochimique présente, lors de son cycle de vie, des performances qui tendent progressivement à se dégrader. Cela peut provenir des changements physico-chimiques irréversibles qui interviennent principalement lors du fonctionnement du dispositif, mais également à l'arrêt de celui-ci.
Il peut alors être essentiel d'avoir une information sur l'état de dégradation générale du dispositif, pour ainsi connaître son avancement dans le cycle de vie.
Par ailleurs, lors du fonctionnement d'un dispositif électrochimique, certains phénomènes physiques peuvent avoir lieu qui entraînent une brusque diminution des performances. Par exemple, dans le cas des piles à combustible du type à membrane échangeuse de protons, les phénomènes d'engorgement et d'assèchement provoquent une dégradation importante des performances de la pile.
Il est donc souhaitable de pouvoir détecter ces phénomènes en temps réel pour y remédier rapidement.
Déterminer l'état de dégradation globale du dispositif, ainsi que détecter certains phénomènes néfastes, revient à déterminer un état de santé du dispositif électrochimique.
L'état de santé du dispositif électrochimique peut être défini comme écart entre la valeur estimée ou mesurée d'au moins un paramètre physico-chimique modélisant au moins en partie le comportement physico-chimique du dispositif électrochimique, et une valeur de référence prédéterminée du même paramètre. Cet écart traduit le caractère opérationnel du dispositif tant à long terme (durée de vie restante) qu'à court terme (apparition de phénomènes physiques qui en diminuent brusquement les performances). Bien entendu, il peut s'agir d'un écart relatif ou absolu.
Bien entendu, la notion d'état de santé recouvre des réalités diverses, qui dépendent des informations que souhaite obtenir l'utilisateur.
D'une manière générale, un état de santé pourra être déterminé à partir d'un ensemble de paramètres caractéristiques donnant une information sur le comportement statique et/ou dynamique dudit dispositif électrochimique. Ces paramètres peuvent représenter les différents phénomènes physico-chimiques intervenant au sein du dispositif électrochimique, comme par exemple des phénomènes liés à la cinétique chimique, des phénomènes ohmiques, et, dans le cas d'une pile à combustible, des phénomènes de diffusion de fluides réactifs jusqu'aux sites de réaction.
A titre d'exemple, déterminer un état de santé d'une pile à combustible de type à membrane échangeuse de protons (PEM, pour *Proton Exchange Membrane)* peut comprendre une estimation en temps réel de certains paramètres comme la résistance électrique interne (généralement assimilée à la résistance électrique de la membrane) de la pile, le taux d'humidité de la membrane, ou encore des paramètres relatifs aux phénomènes de diffusion ou aux phénomènes liés à la cinétique chimique, dans le but de suivre son état de dégradation générale d'une part, et de détecter un phénomène d'assèchement de la membrane d'autre part. Ainsi, il est possible de réagir au plus vite pour éviter que ce type de phénomène ne perdure et ne dégrade la pile de manière irréversible.
Plusieurs méthodes d'estimation de paramètres, pour déterminer un état de santé du dispositif, sont couramment utilisées dans le cadre des piles à combustible de type PEM.
D'une manière générale, chacune des méthodes comprend habituellement une première étape d'obtention des données expérimentales et une seconde étape d'exploitation des mesures pour estimer un ou plusieurs paramètres caractéristiques.
La première étape consiste à appliquer une excitation électrique particulière au dispositif électrochimique et à mesurer la réponse électrique de celui-ci.
La seconde étape est l'analyse des signaux d'entrée et de sortie pour estimer un ou plusieurs paramètres caractérisant au moins en partie le comportement de la pile. Ces paramètres peuvent appartenir à un modèle statique et/ou dynamique représentant le comportement global ou partiel de la pile.
Enfin, on estime un état de santé de la pile comme écart entre la valeur estimée du ou des paramètre(s) avec une valeur de référence prédéterminée du ou des même(s) paramètre(s).
Une première méthode repose sur la technique connue de spectroscopie d'impédance électrochimique. Elle peut être utilisée pour détecter l'engorgement ou l'assèchement d'une pile à combustible, comme le décrit l'article de Fouquet et al. intitulé « Model based PEM fuel cell state-of-health monitoring via ac impedance measurements » et publié en 2006 dans Journal of Power Sources, 159, 905-913.

Un courant d'entrée est appliqué à la pile, qui présente une séquence de perturbations sinusoïdales de faibles amplitudes balayant une large gamme de fréquences. La tension en réponse à ces perturbations est mesurée aux bornes de la pile. Il est alors possible d'obtenir l'impédance de la pile grâce à un dispositif d'analyse d'impédance. Cette impédance peut être tracée dans le plan de Nyquist qui donne l'évolution de la partie imaginaire de l'impédance en fonction de sa partie réelle.

Ensuite, la valeur de paramètres d'un modèle de cette impédance (modèle dynamique petits signaux), du type cellule électrique équivalente, est estimée à partir des signaux mesurés en utilisant une méthode d'optimisation, par exemple la méthode des moindres carrés. Le modèle d'impédance peut être le circuit électrique équivalent suivant :

où $R_{mem}$, $R_{diff}$, $R_{act}$ sont respectivement les résistances de la membrane, de diffusion et d'activation, et $C_{dc}$ et $C_{diff}$ sont respectivement la capacité de double couche et la capacité de la couche équivalente de diffusion. Une description de l'utilisation de ce type de modèle peut être trouvée dans la thèse de Fontès intitulée « Modélisation et caractérisation de la pile PEM pour l'étude des interactions avec les convertisseurs statiques », 2005, Institut National Polytechnique de Toulouse, au paragraphe 3.4.3 « Exploitation des diagrammes d'impédance ».

Le valeur estimée d'un ou plusieurs des paramètres du modèle est ensuite comparée à une valeur de référence prédéterminée du ou des même(s) paramètre(s). L'écart entre la valeur estimée et la valeur de référence caractérise l'état de santé de la pile.

Une seconde méthode d'estimation, également connue de l'homme du métier, repose sur l'étude de la réponse en tension du dispositif électrochimique à l'application d'un échelon de courant, tel que, par exemple, une interruption de courant.

Cette méthode est décrite notamment dans l'article de Cho et al. intitulé « Transient response of a unit proton-exchange membrane fuel cell under various operating conditions » et publié en 2008 dans Journal of Power Sources 185, 118-128.

A partir des mesures du courant appliqué et de la réponse de la tension, il est possible de déduire simplement la résistance électrique interne du dispositif.

Puis, on calcule un écart en comparant la valeur déduite de la résistance électrique interne à une valeur de référence prédéterminée, ledit écart caractérisant l'état de santé de la pile.

Une troisième méthode, dite de balayage à forte amplitude, est décrite dans la thèse de Fontès précédemment citée.

Elle consiste à appliquer au dispositif électrochimique un courant d'entrée périodique, préférentiellement de basse fréquence, et d'une amplitude correspondant à une plage de courant allant sensiblement de zéro au courant nominal, et à mesurer la tension en réponse. Dans la mesure où la fréquence du balayage est très basse, la courbe de polarisation courant/tension est tracée de manière automatique.

Ensuite, les paramètres d'un modèle statique ou dynamique, selon la fréquence du balayage, du dispositif électrochimique décrivant l'évolution de la tension en fonction du courant appliqué sont estimés à l'aide des valeurs expérimentales, par exemple à l'aide d'une méthode d'optimisation du type moindres carrés.

A titre illustratif, comme le montre la thèse de Fontès 2005 au paragraphe 3.4.1 intitulé « Exploitation statique des courbes tension-courant » à propos d'une cellule de pile de type PEM, la courbe expérimentale de polarisation $U_{cellule}=f$ (I), à température et pression constantes, peut être comparée au modèle statique à quatre variables suivant :

$$U_{cellule} = E_{th} - \frac{R.T}{\alpha^* .n.F} \ln\left(\frac{I}{I_0^*}\right) - \left(R_{diff,0} + R_{mem}\right)I$$

où $\alpha^*$ et $I^*_0$ sont des paramètres relatifs aux surtensions d'activation, $R_{mem}$ est la résistance électrique de la cellule du fait principalement des pertes ohmiques dans la membrane, et $R_{diff,0}$ est une résistance liée aux pertes par diffusion, et notamment aux surtensions de diffusion. Comme indiqué plus haut, les différents paramètres du modèle peuvent être estimés à l'aide d'une méthode d'optimisation du type moindres carrés.

Comme précédemment, on calcule ensuite un écart en comparant la valeur estimée d'un ou des paramètre(s) du modèle statique à une valeur de référence prédéterminée du ou des même(s) paramètre(s), ledit écart caractérisant l'état de santé de la pile.

Cependant, le temps d'exécution et/ou la qualité des résultats de chacune de ces différentes méthodes peuvent s'avérer insatisfaisants. Le temps d'exécution d'une méthode désigne ici et dans la suite le temps d'obtention des données expérimentales et de leur traitement pour obtenir les paramètres. La qualité des résultats désigne ici et dans la suite d'une part, la cohérence des paramètres obtenus avec les ordres de grandeurs connus et attendus, et d'autre part, la précision en termes d'intervalles possibles de valeurs pour chacun de ces paramètres (idéalement cet intervalle se réduit à une valeur unique pour chaque paramètre).

De plus, chaque méthode ne peut fournir qu'une information limitée en termes de paramètres accessibles, ce qui peut être insuffisant pour déterminer un état de santé réel du dispositif électrochimique étudié. Une solution pourrait consister à appliquer ces différentes méthodes successivement, mais le temps de traitement serait prohibitif, sans que cela, d'ailleurs, n'améliore la robustesse de chaque méthode.

## EXPOSÉ DE L'INVENTION

Le but de la présente invention est de proposer un procédé de détermination d'un état de santé d'un dispositif électrochimique permettant de résoudre au moins en partie des inconvénients des méthodes de l'art antérieur.

Comme précédemment, l'état de santé du dispositif électrochimique est ici défini comme écart entre la valeur estimée ou mesurée d'au moins un paramètre physico-chimique modélisant au moins en partie le comportement physico-chimique du dispositif électrochimique d'une part, et une valeur de référence prédéterminée du même paramètre d'autre part.

La présente invention se réfère au jeu de revendications.

Par paramètre physico-chimique, on entend un paramètre modélisant au moins en partie le comportement physico-chimique du dispositif électrochimique. Le paramètre physico-chimique peut être un paramètre lié aux phénomènes d'activation ou de diffusion éventuellement présents dans le dispositif. Il peut également être un paramètre électrique tel que, par exemple, la résistance électrique interne du dispositif, l'impédance ou l'admittance de celui-ci.

Lesdites excitations électriques comprises dans le signal d'entrée sont destinées à permettre d'obtenir une caractérisation dudit dispositif électrochimique, c'est-à-dire à estimer au moins un desdits paramètres électriques le définissant.

Le procédé selon l'invention présente ainsi une qualité accrue des résultats, en termes de précision et de cohérence, vis-à-vis des méthodes d'estimation de l'art antérieur.

En effet, l'estimation du ou des paramètre(s) ultérieur(s) est obtenue, selon l'invention, à partir notamment dudit ou desdits premier(s) paramètre(s) précédemment estimé(s). Ainsi, l'information utilisée pour estimer le ou les paramètre(s) ultérieur(s) est plus riche et permet ainsi d'obtenir un résultat de meilleure qualité, c'est-à-dire plus cohérent et plus précis. Le procédé présente donc une fiabilité plus importante.

De plus, le procédé selon l'invention présente une rapidité d'exécution importante dans la mesure où le signal d'entrée comprend les différentes excitations électriques nécessaires à la détermination ultérieure de l'état de santé.

Le procédé présente donc un temps d'exécution particulièrement rapide pour une fiabilité importante.

Selon un mode de réalisation de l'invention, ledit signal d'entrée comprend au moins trois excitations de catégories différentes. Préalablement à l'étape d'estimation dudit au moins un paramètre physico-chimique, on estime au moins un deuxième paramètre à partir d'une excitation électrique appartenant à une deuxième catégorie distincte de la première, du signal de réponse correspondant. L'estimation dudit au moins un paramètre physico-chimique est effectuée à partir d'une excitation électrique appartenant à une troisième catégorie distincte de la première et de la deuxième, du signal de réponse correspondant et dudit au moins un premier paramètre et dudit au moins un deuxième paramètre préalablement estimés.

Ainsi, ledit au moins un paramètre physico-chimique est estimé avec une fiabilité accrue, puisque au moins un premier paramètre et au moins un deuxième paramètre sont utilisés dans cette étape d'estimation. Aussi, la détermination de l'état de santé, ici à partir dudit au moins un paramètre physico-chimique, bénéficie de cette fiabilité accrue.

De préférence, ledit au moins un deuxième paramètre est estimé, en outre, à partir dudit au moins un premier paramètre. Ainsi, ledit au moins un deuxième paramètre est estimé avec une fiabilité accrue, puisqu'au moins un premier paramètre est utilisé dans cette étape d'estimation. Bien entendu, l'estimation dudit au moins un paramètre physico-chimique est alors plus précise et plus cohérente, puisqu'elle utilise l'estimation, elle-même plus précise et plus cohérente, du deuxième paramètre.

Le signal d'entrée selon l'invention comprend une excitation électrique dont la catégorie est une séquence de perturbations sinusoïdale de courant ou de tension, celle-ci étant appliquée de manière à balayer tour à tour une pluralité de sous-suites de fréquences issues de ladite suite principale, chaque sous-suite de ladite pluralité étant entrelacée avec au moins une autre sous-suite de la même pluralité.

L'entrelacement des sous-suites revient à effectuer des allers-retours dans le balayage des fréquences. Aussi, au cours du balayage des fréquences de la suite principale, le fait de solliciter à nouveau les hautes fréquences permet de détecter des phénomènes physiques rapides. De la même manière, le fait de solliciter à nouveau les basses fréquences permet de détecter des phénomènes physiques repérables aux temps longs. Ainsi, tout au long de la mesure, il est possible de repérer des phénomènes physiques lents ou rapides.

Au moins une fréquence d'une première sous-suite est située entre deux fréquences consécutives d'une deuxième sous-suite avec laquelle la première sous-suite est entrelacée.

Chaque sous-suite de ladite pluralité peut alternativement être entrelacée avec toutes les autres sous-suites de la même pluralité.

Les perturbations de ladite séquence peuvent être appliquées de manière à balayer de manière monotone ou aléatoire les fréquences de chaque sous-suite.

De plus, les perturbations de ladite séquence peuvent être appliquées de manière à balayer de manière monotone ou aléatoire lesdites sous-suites de ladite pluralité, les sous-suites étant classées suivant un ordre déterminé.

Les sous-suites peuvent être ordonnées suivant un classement croissant ou décroissant de la fréquence maximale de chaque sous-suite. Alternativement, l'ordre des sous-suites peut dépendre de la fréquence minimale de chaque sous-suite.

D'une manière générale, l'estimation d'un paramètre à partir d'un échelon de courant ou de tension, et du signal de réponse correspondant, consiste avantageusement à :

- soustraire audit signal d'entrée et audit signal de réponse correspondant leur valeur respective précédant l'application de ladite excitation électrique, pour ainsi obtenir la variation de courant et la variation de tension ;
- calculer l'impédance instantanée en divisant ladite variation de tension par ladite variation de courant, et détecter un instant $t_1$, supérieur à l'instant $t_0$ d'application de ladite excitation électrique, pour lequel ladite impédance instantanée présente un minimum ;
- extrapoler ladite impédance instantanée à partir de l'instant $t_1$, et projeter ladite extrapolation à l'instant $t_0$, pour ainsi en déduire la valeur de la résistante électrique interne dudit dispositif électrochimique.

Avantageusement, une évolution expérimentale de la tension en fonction du courant étant obtenue à partir dudit signal d'entrée et dudit signal de réponse correspondant, une évolution modèle de la tension en fonction du courant étant paramétrée par au moins l'un desdits paramètres, l'estimation dudit paramètre à partir d'une variation de courant ou de tension allant de zéro à une valeur nominale est obtenue par :

la minimisation d'une grandeur caractéristique de l'écart existant entre, d'une part, ladite évolution modèle de la tension et de ses N dérivées successives, et d'autre part, ladite évolution expérimentale de la tension et de ses N dérivées successives.

Ledit dispositif électrochimique peut être un électrolyseur ou une pile à combustible.

L'invention a également pour objet un procédé de commande d'un dispositif électrochimique selon la revendication 19.

D'autres avantages et caractéristiques de l'invention apparaîtront dans la description détaillée non limitative ci-dessous.

## BRÈVE DESCRIPTION DES DESSINS

On décrira à présent, à titre d'exemples non limitatifs, des modes de réalisation de l'invention, en se référant aux dessins annexés, parmi lesquels :

La figure 1 est un organigramme du procédé de diagnostic selon un premier mode de réalisation préféré de l'invention, dans lequel deux étapes d'estimation de paramètres sont effectuées successivement ;
La figure 2A est un exemple de signal d'entrée comprenant lesdites excitations de première catégorie et de deuxième catégorie, selon le premier mode de réalisation préféré de l'invention ;
La figure 2B est une partie agrandie du signal représenté sur la figure 2A et compris dans le cadre en trait pointillé.
La figure 3 est un exemple de signal d'entrée comprenant les excitations de première catégorie et de deuxième catégorie, pour la première variante du premier mode de réalisation préféré de l'invention ;

La figure 4 est un exemple de signal d'entrée comprenant les excitations de première catégorie et de deuxième catégorie, pour la deuxième variante du premier mode de réalisation préféré de l'invention ;

La figure 5 est un organigramme du procédé de diagnostic selon un second mode de réalisation préféré de l'invention, dans lequel deux étapes d'estimation de paramètres sont effectuées simultanément et précèdent l'étape d'estimation du troisième paramètre ;

La figure 6 est un exemple de signal d'entrée comprenant lesdites excitations de première, de deuxième et de troisième catégories, pour le deuxième mode de réalisation préféré de l'invention ;

La figure 7 est un organigramme du procédé de diagnostic selon un troisième mode de réalisation préféré de l'invention, dans lequel une étape d'estimation d'au moins un deuxième paramètre est effectuée entre l'étape d'estimation d'au moins un premier paramètre et l'étape d'estimation d'au moins un troisième paramètre ;

Les figures 8A et 8B sont des graphes représentant l'évolution de l'impédance en fonction des perturbations appliquées, en cas de stabilité (figure 8A) et d'instabilité (figure 8B) du système électrique.

## EXPOSÉ DÉTAILLÉ D'UN MODE DE RÉALISATION PRÉFÉRÉ

Le dispositif électrochimique est, dans la suite de la description, une pile à combustible du type à membrane échangeuse de protons.

Le dispositif électrochimique n'est cependant pas limité à une pile à combustible, mais peut être un électrolyseur.

La pile à combustible est connectée à un dispositif de puissance permettant d'imposer un courant électrique, tel qu'une charge active ou un convertisseur statique d'interface avec une application.

Le dispositif de puissance peut être piloté par une entrée de type « signal » permettant de lui imposer un ordre de pilotage.

Un dispositif de mesure est connecté aux bornes de la pile à combustible pour mesurer la tension. De préférence, le dispositif de mesure assure également la mesure du courant réellement appliqué à la pile. Le dispositif de mesure permet également d'assurer l'acquisition des signaux mesurés.

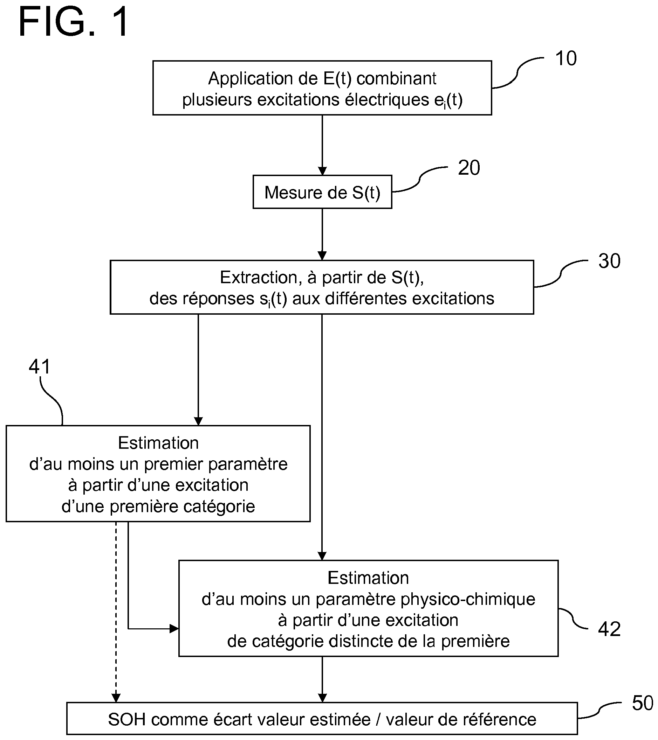

Selon un premier mode de réalisation préféré de l'invention tel que représenté sur la figure 1, le signal d'entrée comprend une pluralité d'excitations électriques, chaque excitation appartenant à une catégorie d'excitations déterminée, ledit signal d'entrée comprenant ici deux excitations de catégories différentes.

Pour la suite de la description, on définit E(t) le signal d'entrée et $e_i^{(1)}$ (t) les excitations électriques de première catégorie, où $i \in [1, N^{(1)}]$ et $N^{(1)}$, supérieur ou égal à 1, est le nombre d'excitations électriques de cette catégorie ; $e_j^{(2)}$(t) les excitations électriques de deuxième catégorie, où $j \in [1, N^{(2)}]$ et $N^{(2)}$, supérieur ou égal à 1, est le nombre d'excitations électriques de cette catégorie ; et $e_k^{(3)}$ (t) les excitations électriques de troisième catégorie, où $k \in [1, N^{(3)}]$ et $N^{(3)}$, supérieur ou égal à 1, est le nombre d'excitations électriques de cette catégorie.

On note également S(t) le signal de sortie et $s_i^{(1)}$ (t) les signaux de réponse aux excitations électriques de première catégorie ; $s_j^{(2)}$(t) les signaux de réponse aux excitations électriques de deuxième catégorie ; et $s_k^{(3)}$ (t) les signaux de réponse aux excitations électriques de troisième catégorie.

Ainsi, dans le premier mode de réalisation préféré, le signal d'entrée E(t), ici le courant électrique, comprend $N^{(1)}$ excitations $e^{(1)}$(t) et $N^{(2)}$ excitations $e^{(2)}$(t), $N^{(1)}$ et $N^{(2)}$ sont, indifféremment l'un de l'autre, supérieurs ou égaux à 1.

Selon le premier mode de réalisation préféré, une excitation électrique de première catégorie est une séquence de perturbations sinusoïdales de courant 71, autour d'un point de polarisation dudit dispositif électrochimique, chaque perturbation ayant une fréquence différente, de manière à parcourir une suite de fréquences déterminée.

L'amplitude des perturbations 71 est suffisamment faible pour que la réponse de la pile reste linéaire. Pour cela, l'amplitude est sensiblement inférieure à 10% de la valeur du courant au point de fonctionnement considéré, et est préférentiellement de l'ordre du pourcent de cette valeur.

Chaque perturbation 71 présente une fréquence différente, et la séquence de perturbations parcourt une suite de fréquences déterminée allant des hautes fréquences vers les basses fréquences, ou inversement. Cette suite de fréquences peut être parcourue de manière monotone, mais peut également être parcourue de différentes manières, tel que décrit plus loin.

La suite de fréquences peut aller de quelques millihertz à quelques dizaines de kilohertz.

Selon le premier mode de réalisation préféré, une excitation électrique de la deuxième catégorie est une variation de courant 73 allant de zéro à une valeur nominale. Par valeur nominale, on entend une valeur maximale du signal pour lequel le fonctionnement de la pile est garanti. Bien entendu, le sens de la variation peut être indifféremment de zéro à une valeur nominale, ou inversement.

Ladite variation de courant 73 est de préférence périodique et de forme sinusoïdale, voire triangulaire. La fréquence est préférentiellement dans la gamme des basses fréquences, par exemple, entre quelques millihertz et quelques hertz, pour être au plus près d'un régime quasi-statique.

L'amplitude varie sensiblement entre une valeur nulle et la valeur du courant nominal.

Par cette catégorie d'excitation, on peut obtenir le tracé automatique de la courbe de polarisation tension/courant de la pile à combustible dans la mesure où la fréquence est basse.

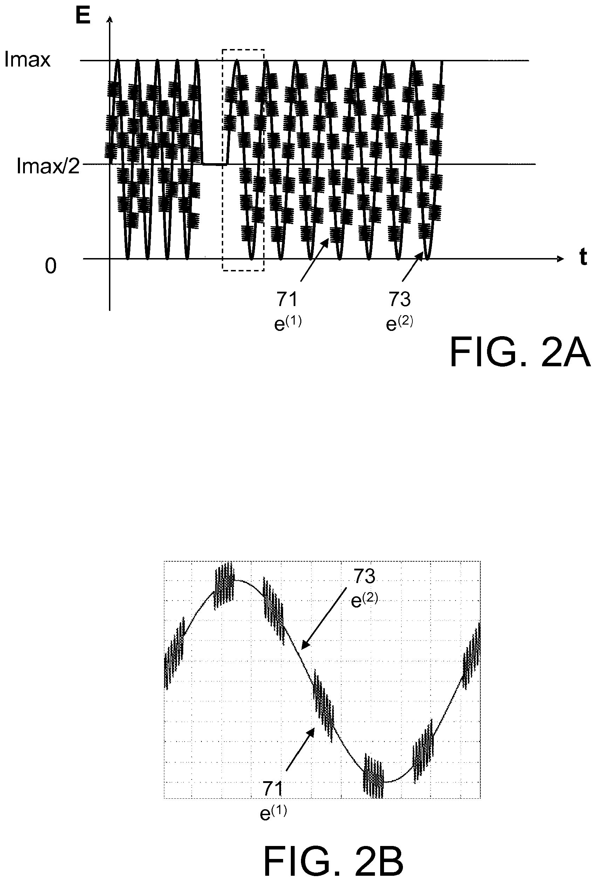

Les figures 2A et 2B montrent un exemple de signal d'entrée comprenant lesdites excitations de première catégorie et de deuxième catégorie. La figure 2B est une partie agrandie du signal de la figure 2A compris dans le cadre en trait pointillé.

Dans le but d'obtenir un signal d'entrée comprenant un maximum d'excitations électriques en un minimum de temps, les excitations électriques $e^{(1)}$ sont temporellement superposées aux excitations $e^{(2)}$.

Le signal de sortie S(t) est mesuré, 20, par le dispositif de mesure. Ledit signal S(t) comprend les signaux de réponse correspondant à chaque excitation électrique appliquée.

Un traitement du signal est effectué pour extraire, 30, du signal de sortie S(t) les signaux de réponse $s^{(1)}$ et $s^{(2)}$ correspondant aux excitations électriques respectives.

Une première étape d'estimation 41 est mise en œuvre, qui permet d'obtenir la valeur d'un premier paramètre caractérisant la pile à partir de l'excitation électrique $e^{(1)}$ et du signal de réponse correspondant $s^{(1)}$.

Un dispositif d'analyse d'impédance donne l'impédance complexe de la pile pour la suite de fréquences balayée. L'évolution de la partie imaginaire de l'impédance en fonction de la partie réelle peut être tracée dans un plan de Nyquist.

Il est à noter que, dans le cas où le signal d'entrée est la tension aux bornes de la pile, le dispositif d'analyse d'impédance déduit l'admittance complexe de la pile, et non plus l'impédance complexe. L'impédance peut néanmoins être aisément déduite de l'admittance.

Les données expérimentales sont ensuite comparées à un modèle dynamique petits signaux du type circuit électrique équivalent caractérisant au moins partiellement le comportement physico-chimique de la pile. Le modèle utilisé peut être celui décrit précédemment en référence à la première méthode d'estimation de paramètres selon l'art antérieur.

Les paramètres du modèle, dont ledit premier paramètre, sont estimés à l'aide d'une procédure classique d'optimisation, par exemple aux moindres carrés.

Dans le cas du modèle décrit précédemment en référence à l'art antérieur, les paramètres peuvent être la résistance de la membrane $R_{mem}$, qui peut être assimilée à la résistance électrique interne de la pile, la résistance de diffusion $R_{diff}$, et la résistance d'activation $R_{act}$, ainsi que la capacité de double couche $C_{dc}$ et la capacité de la couche équivalente de diffusion $C_{diff}$.

De préférence, ledit premier paramètre est la résistance électrique interne de la pile à combustible.

Il est à noter que certains paramètres peuvent être déterminés sans avoir recours à un modèle type circuit électrique équivalent de pile à combustible.

En effet, l'intersection de l'évolution de l'impédance avec l'axe des réels vers les hautes fréquences définit la valeur de la résistance électrique principalement due à la chute ohmique dans la membrane de la pile. On peut ensuite en déduire le taux d'hydratation de la membrane, et ainsi détecter rapidement les phénomènes d'assèchement de la membrane, phénomènes particulièrement néfastes pour la structure de la membrane et les performances de la pile.

A la suite de ladite première étape d'estimation, est effectuée une seconde étape d'estimation 42 pour estimer un paramètre physico-chimique caractérisant la pile à partir d'une excitation électrique appartenant à une deuxième catégorie $e^{(2)}$, du signal de réponse correspondant $s^{(2)}$ et dudit premier paramètre précédemment estimé.

On rappelle que, selon le premier mode de réalisation préféré de l'invention, une excitation électrique de la deuxième catégorie est une variation de courant allant de zéro à une valeur nominale 73.

A partir des signaux mesurés, on exprime la tension en fonction du courant appliqué.

S'il apparaît une hystérésis, on moyenne les valeurs pour obtenir une relation bijective entre la tension et le courant.

Les données expérimentales sont ensuite comparées à un modèle statique de pile à combustible dans lequel la tension est exprimée en fonction du courant.

Le modèle statique peut être celui décrit précédemment en référence à la troisième méthode d'estimation de paramètres selon l'art antérieur.

Les paramètres du modèle sont estimés à l'aide d'une procédure classique d'optimisation, par exemple aux moindres carrés.

Ces paramètres peuvent être, dans le cas du modèle statique précédemment décrit, $\alpha^*$ et $I^*_0$ des paramètres relatifs aux surtensions d'activation, $R_{mem}$ la résistance électrique de la cellule, et $R_{diff,0}$ une résistance liée aux pertes par diffusion, et notamment aux surtensions de diffusion.

Cependant, à la différence de la première étape d'estimation 41 qui estime le premier paramètre à partir des seules données expérimentales, la deuxième étape d'estimation 42 utilise non seulement les données expérimentales, mais également la valeur préalablement estimée dudit premier paramètre.

Concernant l'utilisation de l'estimation du premier paramètre par la deuxième étape d'estimation 42, une première situation se présente si le premier paramètre est différent du paramètre physico-chimique, par exemple si le premier paramètre est la résistance électrique interne de la pile et le paramètre physico-chimique est un desdits paramètres relatifs aux phénomènes d'activation ou de diffusion.

Dans ce cas, la procédure d'optimisation est initiée en imposant au paramètre du modèle statique identique audit premier paramètre, la valeur estimée du premier paramètre, et aux autres paramètres, dont ledit paramètre physico-chimique, une valeur initiale aléatoire.

La valeur imposée peut alors être considérée comme une valeur fixe, auquel cas le nombre de paramètres du modèle statique à estimer est moindre. La deuxième étape d'estimation 42 est ainsi plus rapide du fait du nombre réduit de paramètres à estimer.

Alternativement, la valeur imposée peut être considérée comme une valeur initiale. Aussi, la deuxième étape d'estimation 42 va estimer également ce paramètre. Cependant, le temps de convergence vers la valeur finale est particulièrement court dans la mesure où la valeur initiale, estimée par la première étape et donc proche de la valeur réelle, est proche de la valeur finale.

Une seconde situation, concernant l'utilisation de l'estimation du premier paramètre par la deuxième étape d'estimation 42, correspond au cas où le premier paramètre et le paramètre physico-chimique sont identiques. Par exemple, il s'agit de la résistance électrique interne de la pile, ou la résistance de diffusion.

Dans ce cas, la procédure d'optimisation est initiée en imposant au paramètre physico-chimique la valeur estimée lors de la première étape d'estimation 41.

La valeur imposée peut alors être considérée comme une valeur initiale. Aussi, la deuxième étape d'estimation 42 va estimer également ce paramètre. Cependant, de la même manière que précédemment, le temps de convergence vers la valeur finale est particulièrement court.

Dans tous les cas, outre la rapidité accrue de la deuxième étape d'estimation, celle-ci est rendue plus robuste, c'est-à-dire que la probabilité d'obtenir des valeurs incohérentes est réduite. Il est à noter que la robustesse, d'une manière générale, diminue lorsque le nombre de paramètres à déterminer augmente. La robustesse est également améliorée lorsque les valeurs initiales sont particulièrement proches des valeurs réelles.

Ensuite, on calcule, 50, un écart entre la valeur estimée du paramètre physico-chimique et une valeur de référence prédéterminée du même paramètre, cet écart caractérisant ledit état de santé de la pile.

Il est à noter qu'il est possible de calculer d'autres écarts à partir des valeurs estimées de paramètres lors de la première et/ou seconde étape(s) d'estimation, et des valeurs de référence prédéterminées pour les mêmes paramètres. Ces écarts supplémentaires caractérisent, également, ledit état de santé.

A titre illustratif, l'état de santé peut être estimé comme écart entre la valeur estimée de la résistance électrique de la pile et une valeur de référence de cette résistance d'une part, et comme écart entre la valeur estimée d'un paramètre relatif aux phénomènes de diffusion ou d'activation et une valeur de référence prédéterminée du même paramètre d'autre part.

Selon une première variante du premier mode de réalisation préféré de l'invention, l'excitation électrique de première catégorie est non plus une séquence de perturbations sinusoïdales, mais un échelon de courant 72.

Par échelon, on entend le passage idéalement instantané d'une valeur initiale à une valeur finale différente. L'interruption de courant est un exemple d'échelon couramment utilisé.

L'excitation électrique de deuxième catégorie reste identique à celle décrite précédemment.

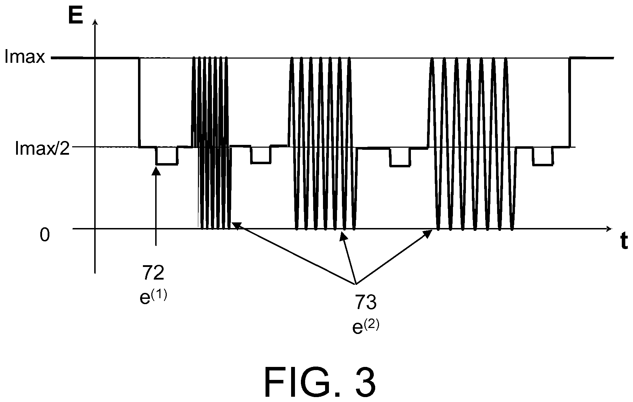

La figure 3 montre un exemple de signal d'entrée comprenant lesdites excitations de première catégorie et de deuxième catégorie, pour cette variante du premier mode de réalisation préféré de l'invention.

Au moins un échelon de courant 72 est disposé entre deux excitations électriques de deuxième catégorie. Ainsi, les excitations de première catégorie et celles de deuxième catégorie sont appliquées de manière séquentielle.

Après l'étape d'extraction des signaux de réponse $s^{(1)}$ et $s^{(2)}$ correspondant aux excitations $e^{(1)}$ et $e^{(2)}$, étape identique à celle décrite précédemment, est mise en œuvre la première étape d'estimation 41 du premier paramètre.

Les résultats expérimentaux sont analysés dans le but de déterminer préférentiellement la résistance électrique interne de la pile.

Selon une procédure connue de l'homme du métier, on mesure l'échelon de courant effectif $\Delta I$ ainsi que le saut de tension $\Delta U$ en réponse, et on en déduit la valeur de la résistance interne Re, par exemple en calculant directement le rapport $\Delta U/\Delta I$ à l'instant (idéalement) d'application de l'échelon.

Alternativement, et également de manière connue, on peut obtenir la résistance interne à partir de la dérivée temporelle de la tension et du courant. La résistance interne est alors obtenue à partir de la relation :

$$\mathrm{Re} = \frac{\max\left|\partial_t u\right|}{\max\left|\partial_t i\right|}$$

Enfin, une autre procédure d'obtention de la résistance interne est préférentiellement utilisée.

On définit $t_0$ l'instant d'application de l'échelon de courant.

On calcule la variation de courant $\Delta I$ en soustrayant à la valeur du courant en fonction du temps la valeur du courant avant l'échelon. On procède au même calcul pour la tension. On a ainsi $\Delta I(t)=I(t)-I_{init}$ et $\Delta U(t)=U(t)-U_{init}$.

On calcule ensuite le vecteur Impédance instantanée à partir des vecteurs Variation de courant et de tension : $Z(t) = \Delta U(t) / \Delta I(t)$.

On détecte l'instant $t_1$ supérieur strictement à $t_0$ pour lequel l'impédance $Z(t)$ passe par un minimum.

Puis, pour $t \geq t_1$, on approxime $Z(t)$ par une fonction numérique, par exemple un polynôme de degré n.

Enfin, la résistance électrique interne de la pile correspond à la valeur de cette fonction numérique pour $t = t_0$.

Cette procédure présente l'avantage d'être complètement automatisable. L'intervention d'un opérateur pour sélectionner une valeur n'est donc pas requise. Cette procédure s'avère être particulièrement précise et robuste. Ainsi, il a pu être montré que l'erreur relative était inférieure à 0,5% par rapport à une mesure par spectroscopie d'impédance précédant immédiatement l'échelon.

Ensuite est effectuée la deuxième étape d'estimation 42 qui permet d'estimer le paramètre physico-chimique à partir de l'excitation électrique de deuxième catégorie, du signal de réponse correspondant, et du premier paramètre préalablement estimé, ici la résistance interne. Cette deuxième étape est identique ou similaire à celle décrite précédemment, et n'est donc pas reprise ici. Ici, le paramètre physico-chimique peut être la résistance électrique interne ou un paramètre relatif au phénomène d'activation ou de diffusion.

Ensuite, on calcule, 50, un écart entre la valeur estimée du paramètre physico-chimique et une valeur de référence prédéterminée du même paramètre, cet écart caractérisant ledit état de santé de la pile.

Comme mentionné précédemment, il est possible de calculer d'autres écarts à partir des valeurs estimées de paramètres lors de la première et/ou seconde étape(s) d'estimation, et des valeurs de référence prédéterminées pour les mêmes paramètres. Ces écarts supplémentaires caractérisent, également, ledit état de santé.

Dans une deuxième variante du premier mode de réalisation préféré de l'invention, le procédé est similaire à celui décrit précédemment, à ceci près que l'excitation de première catégorie est un échelon de courant 72 et que l'excitation de deuxième catégorie est une séquence de perturbations sinusoïdales de courant ou de tension 71, autour d'un point de polarisation dudit dispositif électrochimique, chaque perturbation ayant une fréquence différente, de manière à parcourir une suite de fréquence déterminée.

Ces différentes excitations sont identiques ou similaires à celles décrites précédemment.

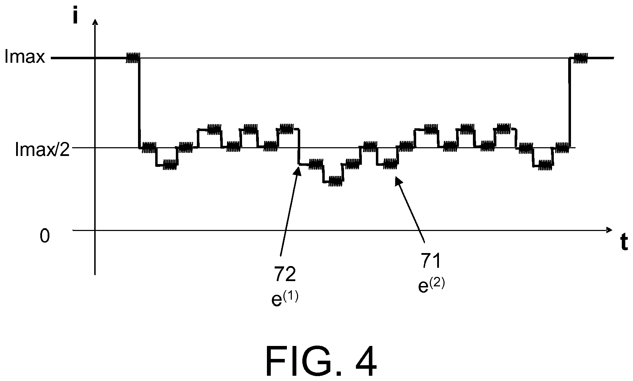

La figure 4 est un exemple de signal d'entrée comprenant lesdites excitations de première catégorie et de deuxième catégorie, pour cette deuxième variante du premier mode de réalisation préféré de l'invention.

Au moins un échelon de courant 72 est disposé entre deux perturbations sinusoïdales 71. Ainsi, les excitations de première catégorie et celles de deuxième catégorie sont appliquées de manière séquentielle.

Après l'étape d'extraction des signaux de réponse $s^{(1)}$ et $s^{(2)}$ correspondant aux excitations $e^{(1)}$ et $e^{(2)}$, étape identique à celle décrite précédemment, est mise en œuvre la première étape d'estimation 41 du premier paramètre.

Celle-ci est identique à celle décrite dans la première variante du premier mode de réalisation de l'invention, et n'est donc pas reprise ici. Le premier paramètre est de préférence la résistance électrique interne de la pile à combustible.

Est ensuite mise en œuvre la deuxième étape d'estimation 42, similaire à celle décrite pour le premier mode de réalisation de l'invention, à ceci près que le paramètre physico-chimique est estimé à partir notamment du premier paramètre.

Les données expérimentales sont comparées à un modèle dynamique petits signaux de type circuit électrique équivalent caractérisant au moins partiellement le comportement physico-chimique de la pile.

Les paramètres du modèle, dont ledit premier paramètre, sont estimés à l'aide d'une procédure classique d'optimisation, par exemple aux moindres carrés.

Concernant l'utilisation de l'estimation du premier paramètre par la deuxième étape d'estimation, les deux situations précédemment décrites concernant l'identité des premier et deuxième paramètres se retrouvent ici.

Ensuite, on calcule, 50, un écart entre la valeur estimée du paramètre physico-chimique et une valeur de référence prédéterminée du même paramètre, cet écart caractérisant ledit état de santé de la pile.

Comme mentionné précédemment, il est possible de calculer d'autres écarts à partir des valeurs estimées de paramètres lors de la première et/ou seconde étape(s) d'estimation, et des valeurs de référence prédéterminées pour les mêmes paramètres. Ces écarts supplémentaires caractérisent, également, ledit état de santé.

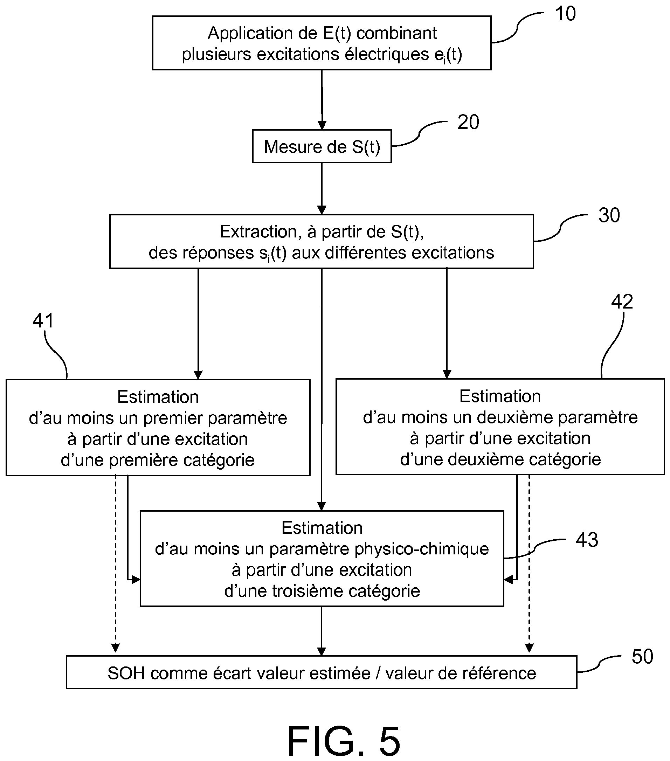

Un deuxième mode de réalisation préféré de l'invention est maintenant décrit en détail, en référence à la figure 5, dans lequel le signal d'entrée comprend au moins trois excitations de catégories différentes.

Les catégories d'excitation sont similaires ou identiques aux trois catégories décrites précédemment.

Selon le deuxième mode de réalisation préféré, une excitation de première catégorie est un échelon de courant 72. Une excitation de deuxième catégorie est une séquence de perturbations sinusoïdales 71 de courant, autour d'un point de polarisation dudit dispositif électrochimique, chaque fréquence ayant une fréquence différente, de manière à parcourir une suite de fréquences déterminée. Et une excitation de troisième catégorie est une variation de courant, en basses fréquences, entre zéro et une valeur nominale 73.

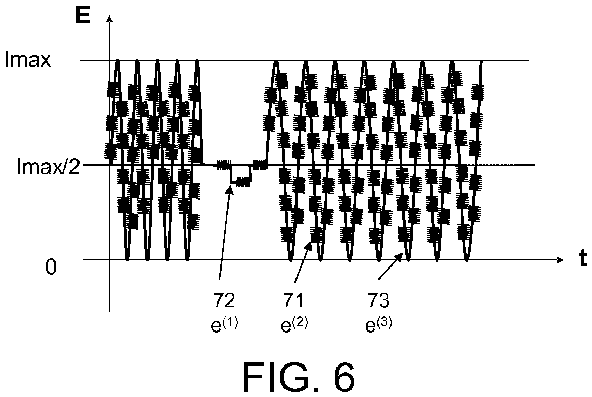

La figure 6 est un exemple de signal d'entrée comprenant lesdites excitations de première, de deuxième et de troisième catégories, pour ce deuxième mode de réalisation préféré de l'invention.

Au moins un échelon de courant 72 est disposé entre deux perturbations sinusoïdales 71. Ainsi, les excitations de première catégorie et celles de deuxième catégorie sont appliquées de manière séquentielle.

Dans le but d'obtenir un signal d'entrée comprenant un maximum d'excitations électriques en un minimum de temps, les excitations électriques de deuxième catégorie sont temporellement superposées, au moins en partie, aux excitations de troisième catégorie.

Le procédé comprend une deuxième étape d'estimation 42 effectuée avant l'étape d'estimation 43 du paramètre physico-chimique. Cette deuxième étape 42 consiste à estimer un deuxième paramètre à partir d'une excitation électrique appartenant à une deuxième catégorie et du signal de réponse correspondant.

Selon ce mode de réalisation, le paramètre physico-chimique est ensuite estimé à partir dudit premier paramètre et dudit deuxième paramètre.

Après l'étape d'extraction des signaux de réponse $s^{(1)}$, $s^{(2)}$ et $s^{(3)}$ correspondant aux excitations $e^{(1)}$, $e^{(2)}$ et $e^{(3)}$, étape sensiblement identique à celle décrite précédemment, est mise en œuvre la première étape d'estimation du premier paramètre.

La première étape d'estimation 41 est identique à celle décrite dans la première variante du premier mode de réalisation de l'invention.

La seconde étape d'estimation 42 est effectuée, de préférence simultanément à la première étape d'estimation. Elle est identique à celle décrite dans le premier mode de réalisation de l'invention, dans lequel elle correspondait alors à la première étape d'estimation.

Puis, est mise en œuvre la troisième étape d'estimation 43 du paramètre physico-chimique à partir d'une excitation de troisième catégorie, du signal de réponse correspondant et desdits premier et deuxième paramètres précédemment estimés.

Ensuite, on calcule, 50, un écart entre la valeur estimée du paramètre physico-chimique et une valeur de référence prédéterminée du même paramètre, ledit écart caractérisant ledit état de santé de la pile.

Comme mentionné précédemment, il est possible de calculer d'autres écarts à partir des valeurs estimées de paramètres lors de la première et/ou seconde et/ou troisième étape(s) d'estimation, et des valeurs de référence prédéterminées pour les mêmes paramètres. Ces écarts supplémentaires caractérisent, également, ledit état de santé.

Ainsi, le paramètre physico-chimique est estimé avec plus de précision. Le procédé est ainsi rendu plus précis et plus robuste.

Comme dans le premier mode de réalisation préféré, ou comme dans la première variante du premier mode, le premier paramètre est de préférence la résistance électrique interne de la pile.

Le deuxième paramètre peut être la résistance électrique interne, ou l'un des paramètres relatifs aux chutes de tension dues aux phénomènes d'activation ou de diffusion, par exemple la résistance de diffusion.

Le paramètre physico-chimique peut être la résistance électrique interne, ou l'un des paramètres relatifs aux chutes de tension dues aux phénomènes d'activation ou de diffusion, par exemple la résistance de diffusion.

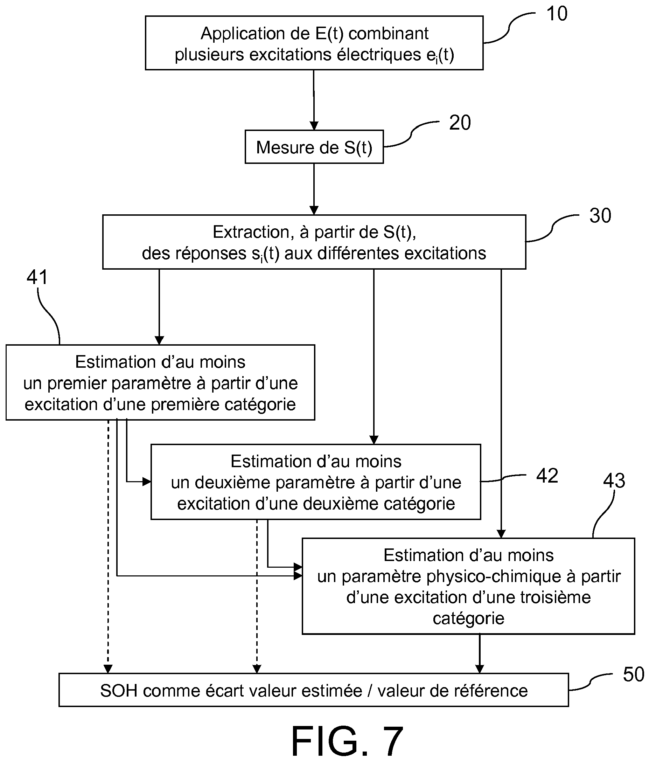

Un troisième mode de réalisation préféré de l'invention est maintenant décrit, en référence à la figure 7, dans lequel le signal d'entrée comprend au moins trois excitations de catégories différentes.

Ce troisième mode de réalisation est sensiblement identique au deuxième mode de réalisation qui vient d'être décrit.

Cependant, la deuxième étape d'estimation 42 n'est pas effectuée simultanément à la première étape 41, mais après celle-ci. De plus, la deuxième étape estime le deuxième paramètre à partir notamment du premier paramètre précédemment estimé.

Ainsi, le deuxième paramètre est estimé avec une précision accrue. L'estimation du paramètre physico-chimique bénéficie directement de cette plus grande précision. Le procédé est ainsi rendu plus précis et plus robuste.

Comme il a été décrit précédemment, le procédé peut comprendre une excitation électrique du type séquence de perturbations sinusoïdales 71 de courant, autour d'un point de polarisation dudit dispositif électrochimique, chaque perturbation ayant une fréquence différente, appartenant à une suite principale de fréquences.

Le point de polarisation reste, de préférence, constant tout le long de l'application de la séquence de perturbations.

Chaque perturbation comprend, de préférence, quelques périodes pour que s'amortisse un éventuel régime transitoire, puis quelques périodes pour le calcul de l'impédance.

Chaque perturbation a une fréquence différente, de sorte que la séquence de perturbation balaye une suite principale A de fréquences $A = \{f_1, f_2,..., f_N\}$. Plus précisément, la séquence de perturbations comporte au moins une perturbation pour chaque fréquence de la suite A.

La gamme de la suite principale A de fréquences peut aller de quelques millihertz à quelques dizaines de kilohertz, et comprend N fréquences à balayer, par exemple, une centaine de fréquences.

L'amplitude des perturbations est suffisamment faible pour que la réponse de la pile reste linéaire. Pour cela, l'amplitude est sensiblement inférieure à 10% de la valeur du courant au point de fonctionnement considéré, et est préférentiellement de l'ordre du pourcent de cette valeur.

Un dispositif d'analyse d'impédance donne l'impédance complexe de la pile pour chacune des fréquences de la suite principale A. Il est alors possible de tracer l'évolution de la partie imaginaire de l'impédance en fonction de la partie réelle dans un plan de Nyquist.

Il est à noter que, dans le cas où le signal d'entrée est la tension aux bornes de la pile, le dispositif d'analyse d'impédance déduit l'admittance complexe de la pile, et non plus l'impédance complexe. L'impédance peut néanmoins être aisément déduite de l'admittance.

Les fréquences de ladite suite principale A sont distribuées de manière à former une pluralité de sous-suites $A^1,...,A^n$ de fréquences.

Par sous-suite $(A^i)_{i=1...n}$ de fréquences, on entend un ensemble de fréquences extraites, ou issues, de la suite principale A :

$$A^i = \left\{ f_j^i \,/\, f_j^i \in A \right\}$$

La réunion des sous-suites $(A^i)_{i=1...\eta}$ correspond à la suite principale A de fréquences :

$$A = \bigcup_{i=1}^{n} A^i$$

De préférence, chaque sous-suite ne contient pas de fréquences en commun avec une autre sous-suite :

$$\bigcap_{i=1}^{n} A^i = \varnothing$$

De préférence, chaque sous-suite $(A^i)_{i=1...n}$ de fréquences comporte $N^i$ fréquences, de sorte que la somme des $N^i$ fréquences égale le nombre N de fréquences de la suite principale A :

$$\sum_{i=1}^{n} N^i = N$$

Chaque sous-suite $A^i$ présente une gamme de fréquences. Par gamme $G^i$ de la sous-suite $A^i$, on entend l'ensemble des fréquences de la sous-suite considérée comprises entre la plus haute fréquence et la plus basse fréquence de ladite sous-suite. Ainsi :

$$G^i = \left\{ f_j^i \,/\, \forall j \in \left[1, N^i\right], f_{(\min)}^i \leq f_j^i \leq f_{(\max)}^i \right\}$$

avec

$$f_{(\min)}^i = \min\left(A_i\right) \qquad f_{(\max)}^i = \max\left(A_i\right)$$

Chaque sous-suite $A^i$ de ladite pluralité de sous-suites est entrelacée avec au moins une autre sous-suite $A^{i'}$ de la même pluralité.

Par entrelacement de deux sous-suites $A^i$ et $A^{i'}$, on entend la présence d'au moins une fréquence d'une première sous-suite entre deux fréquences consécutives de la deuxième sous-suite.

Plus précisément, il y a entrelacement entre les sous-suites $A^i$ et $A^{i'}$ telles que

$$A^i = \left\{ f_j^i \right\}_{j \in \left[1, N^i\right]}$$

*et*

$$A^{i'} = \left\{ f_k^{i'} \right\}_{k \in \left[ 1, N^{i'} \right]}$$

si :

$$\exists j_0 \ / \ f_k^{i'} \le f_{j_0}^{i} \le f_{k+1}^{i'}$$

ou si :

$$\exists k_0 \ / \ f_j^{i} \le f_{k_0}^{i'} \le f_{j+1}^{i}$$

Dans une première variante, chaque sous-suite est entrelacée avec toutes les autres sous-suites de ladite pluralité.

Chaque sous-suite est parcourue par la séquence de perturbations de manière monotone, dans la même direction, de préférence des hautes fréquences vers les basses fréquences.

De plus, ladite pluralité de sous-suites de fréquences est parcourue de manière monotone. Par ordre monotone, on entend que la pluralité de sous-suites de fréquences est parcourue de sous-suite en sous-suite voisine, suivant un classement ordonné des sous-suites. De préférence, lesdites sous-suites sont classées suivant l'ordre décroissant de la fréquence maximale de chaque sous-suite.

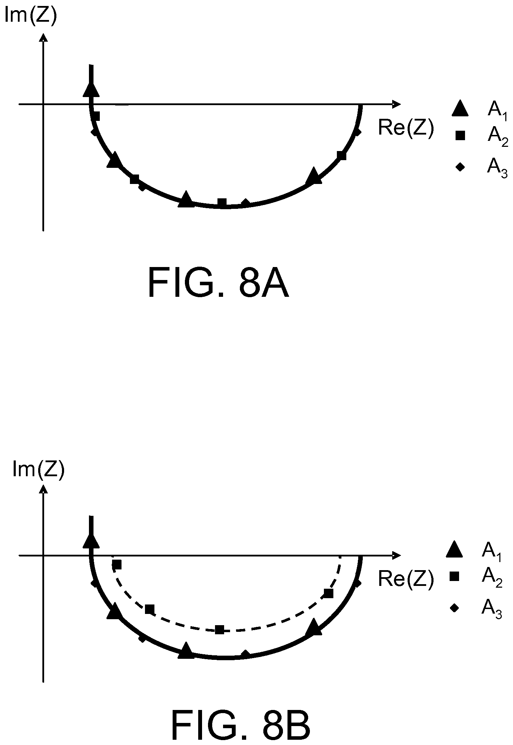

A titre d'exemple, et comme l'illustrent les figures 8A et 8B, la suite principale A de fréquences à balayer est de 2Hz à 10kHz, et comporte 12 fréquences. Aussi, la suite A est : A = {10kHz, 5kHz, 2kHz, 1kHz, 500Hz, 200Hz, 100Hz, 50Hz, 20Hz, 10Hz, 5Hz, 2Hz}.

Trois sous-suites $A^1$, $A^2$, $A^3$ sont formées à partir de la suite principale A par décimation d'une fréquence sur trois :

$A^1$ = {10kHz, 1kHz, 100Hz, 10Hz}
$A^2$ = {5kHz, 500Hz, 50Hz, 5Hz}
$A^3$ = {2kHz, 200Hz, 20Hz, 2Hz}

Selon cette variante, chaque sous-suite de fréquences présente au moins une fréquence comprise entre deux fréquences consécutives d'une autre sous-suite. Il y a donc entrelacement entre chacune des trois sous-suites, et non pas seulement entre deux sous-suites voisines.

Ainsi, au lieu d'appliquer la séquence de perturbations de manière à balayer continûment les N fréquences de la suite principale A, comme dans la solution classique de l'art antérieur décrite précédemment, la séquence de perturbations parcourt tour à tour les trois sous-suites de fréquences.

La séquence de perturbations parcourt successivement, de préférence, les fréquences de la sous-suite $A^1$ puis celles de la sous-suite $A^2$ etc.

Ainsi, en entrelaçant lesdites sous-suites, le procédé permet de savoir rapidement si le système est resté stable pendant la durée des mesures.

En effet, en cas d'instabilité de la pile à combustible, dès l'application de la sous-suite $A^i$, les points expérimentaux de l'impédance pour les fréquences de cette sous-suite ne se situent pas dans la continuité des points correspondant à l'impédance mesurée pour la sous-suite précédente $A^{i-1}$.

Par exemple, comme l'illustrent les figures 8A et 8B, l'application des perturbations balayant la sous-suite $A^1$ permet d'obtenir les valeurs de l'impédance $Z(A^1)$ pour les fréquences considérées : Z(10kHz), Z (1kHz) , Z (100Hz)...

Les valeurs de l'impédance $Z(A^2)$ pour les fréquences de la sous-suite $A^2$ devraient, si la pile était restée stable le temps de la mesure, se placer en continuité avec celles de $Z(A^1)$. Comme le montre la figure 8A (pile stable), les valeurs de l'impédance pour chaque sous-suite de fréquences se placent continûment le long d'une courbe donnée (trait continu).

Si la pile devient instable entre les sous-suites $A^1$ et $A^2$, une discontinuité apparaît entre $Z(A^1)$ et $Z(A^2)$ dans la zone de recouvrement entre les gammes de ces deux sous-suites. La figure 8B illustre cette discontinuité. Les valeurs de $Z(A^2)$ se placent sur une courbe (trait en pointillé) différente de celle de $Z(A^1)$ (trait continu). La discontinuité apparaît dès la première valeur de $Z(A^2)$ correspondant à la première fréquence appliquée de la sous-suite $A^2$.

On peut évaluer simplement la discontinuité dans la zone de recouvrement considérée. Ainsi, une première fréquence $f_i^1$ d'une première sous-suite $A^1$ est située entre deux fréquences consécutives $f_j^2$ et $f_{j+1}^2$ d'une seconde sous-suite $A^2$. Les première et seconde sous-suites $A^1$ et $A^2$ sont donc entrelacées.

On calcule une valeur de l'impédance pour la première fréquence $Z_{int}(f^1{}_i)$ à partir des impédances correspondant aux deux fréquences $Z(f^2{}_j)$ et $Z(f^2{}_{j+1})$ de la seconde sous-suite. Ce calcul peut être réalisé, par exemple, par interpolation linéaire, cubique (par spline cubique) ou polynomiale.

On calcule ensuite un écart entre la valeur de l'impédance estimée pour une première fréquence $Z(f^1{}_i)$ et la valeur de l'impédance obtenue par interpolation $Z_{int}(f^1{}_i)$ .

On compare enfin l'écart calculé à un écart seuil prédéterminé. Lorsque cet écart dépasse l'écart seuil, on en déduit une instabilité de la pile à combustible.

Ainsi, la séquence de perturbations permet de savoir rapidement si le système est resté stable pendant la durée des mesures.

De plus, le fait de solliciter à nouveau les hautes fréquences, ici en début de chaque sous-suite, permet de repérer d'éventuels phénomènes physiques rapides tout au long de la mesure.

Bien entendu, cet exemple n'est donné qu'à titre illustratif. Il est possible d'augmenter ou de diminuer le nombre de sous-suites, et donc de diminuer respectivement ou d'augmenter le nombre de fréquences dans chaque sous-suite.

Par exemple, pour une suite principale A comportant 400 fréquences, la séquence de perturbations peut parcourir une vingtaine de sous-suites de fréquences comportant chacune une vingtaine de fréquences.

Selon une deuxième variante, chaque sous-suite $A^i$ de fréquences n'est entrelacée qu'avec la ou les sous-suite (s) voisine (s) $A^{i-1}$ et $A^{i+1}$. A l'exception de cette différence, le deuxième mode de réalisation reste similaire au premier mode.

A titre d'exemple, pour la suite principale suivante A = {10kHz, 5kHz, 2kHz, 1kHz, 500Hz, 200Hz, 100Hz, 50Hz, 20Hz, 10Hz, 5Hz, 2Hz}, les sous-suites peuvent être :

$A^1$ = {10kHz, 2kHz}
$A^2$ = {5kHz, 500Hz}
$A^3$ = {1kHz, 100Hz}
$A^4$ = {200Hz, 20Hz}
$A^5$ = {50Hz, 5Hz}
$A^6$ = {10Hz, 2Hz}

La séquence de perturbations balaie les sous-suites tour à tour, suivant l'ordre décroissant des fréquences maximales.

Ainsi, la séquence des perturbations présente un mouvement présentant une succession d'allers-retours, tout en allant progressivement des hautes fréquences vers les basses fréquences.

Comme décrit précédemment, en cas d'instabilité de la pile, une discontinuité dans les valeurs de l'impédance apparaît au niveau des zones de recouvrement entre sous-suites voisines.

Cette discontinuité peut être exploitée pour diagnostiquer une défaillance naissante, comme par exemple un assèchement ou un engorgement d'une pile à combustible, et conduire à une rétroaction sur le contrôle-commande de la pile à combustible.

Pour les différentes variantes décrites précédemment, les fréquences de chaque sous-suite $A^i$ peuvent être balayées, non plus de manière monotone, mais aléatoire, par ladite séquence de perturbations.

De la même manière, ladite pluralité de sous-suites de fréquences $A^1,...,A^n$ peut être parcourue de manière aléatoire par ladite séquence de perturbations.

Il est à noter qu'une spectroscopie entrelacée, quelles que soient les variantes décrites précédemment, présente un résultat identique, lorsque la pile reste stable, à celui d'une spectroscopie classique.

Est maintenant décrite une variante d'étape d'estimation d'un paramètre à partir d'une excitation électrique du type variation de courant allant de zéro à une valeur nominale.

Comme il a été décrit dans le premier mode de réalisation préféré, les données expérimentales mesurées sont comparées à un modèle statique de pile à combustible dans lequel la tension est exprimée en fonction du courant. Les paramètres du modèle sont estimés à l'aide d'une procédure classique d'optimisation, par exemple aux moindres carrés.

Pour améliorer la fiabilité des résultats, il est possible de comparer, non plus seulement la courbe expérimentale $U_{exp}=f(I_{exp})$ à la courbe du modèle statique $U_{th}=f(I_{th})$, mais cette même courbe expérimentale et ses dérivées successives $\partial_I U_{exp}$, $\partial_{II} U_{exp...}$ à la courbe modèle et ses dérivées successives $\partial_I U_{th}$, $\partial_{II} U_{th...}$, respectivement.

Ainsi, la procédure d'optimisation minimise l'écart entre le système d'équations issues des données expérimentales et le système d'équations issues du modèle statique.

Dans la mesure où le nombre d'inconnues reste le même alors que celui des équations est augmenté, la probabilité d'obtenir des résultats incohérents est fortement diminuée, ce qui améliore sensiblement la fiabilité du procédé.

Il est à noter que les modes de réalisation de l'invention décrits précédemment restent similaires dans le cas où le signal d'entrée appliqué à la pile à combustible est la tension aux bornes de celle-ci.

Enfin, l'invention concerne également un procédé de commande d'un dispositif électrochimique comportant :

- la détermination d'un état de santé selon l'une quelconque des caractéristiques précédentes ; puis
- l'application d'une commande audit dispositif électrochimique lorsque ledit écart dépasse un écart seuil prédéterminé.

Ainsi, lorsque l'état de santé déterminé indique l'assèchement de la membrane d'une pile, l'application d'une commande à la pile permet notamment d'éviter que l'assèchement ne perdure et ne détériore la membrane.

**Revendications**

1. Procédé de détermination d'un état de santé d'un dispositif électrochimique, de type pile à combustible, à partir d'au moins un paramètre physico-chimique modélisant au moins en partie le comportement physico-chimique dudit dispositif électrochimique, ledit procédé étant **caractérisé en ce qu'**il comporte les étapes consistant à :

   - appliquer (10) audit dispositif électrochimique un signal d'entrée comprenant une pluralité d'excitations électriques, chaque excitation appartenant à une catégorie d'excitations déterminée choisie parmi un ensemble formé d'une séquence de perturbations sinusoïdales de courant ou de tension, autour d'un point de polarisation dudit dispositif électrochimique, l'amplitude des perturbations étant inférieure à 10% d'une valeur du courant audit point de polarisation pour que la réponse du dispositif électrochimique reste linéaire, chaque perturbation ayant une fréquence différente appartenant à une suite principale (A) de fréquences, ladite séquence de perturbations étant appliquée de manière à balayer tour à tour une pluralité de sous-suites $(A_1,...,A_n)$, chacune desdites sous-suites $(A_1,...,A_n)$ étant un ensemble de fréquences issues de la suite principale (A), chaque sous-suite de ladite pluralité étant entrelacée avec au moins une autre sous-suite de la même pluralité de sorte qu'elle comporte au moins une fréquence comprise entre deux fréquences consécutives de ladite au moins une sous-suite avec laquelle elle est entrelacée ; d'un échelon de courant ou de tension ; et d'une variation de courant ou de tension allant de zéro à une valeur nominale, ledit signal d'entrée comprenant au moins deux excitations de catégories différentes dont au moins une étant ladite séquence de perturbations sinusoïdales de courant ou de tension, et mesurer un signal de sortie (20) dudit dispositif électrochimique en réponse audit signal d'entrée ; puis
   - extraire (30), à partir dudit signal de sortie, les signaux de réponse associés à chacune desdites excitations électriques ; puis
   - estimer (41) au moins un premier paramètre à partir d'une excitation électrique appartenant à une première catégorie parmi lesdites au moins deux excitations de catégories différentes préalablement appliquées, et du signal de réponse correspondant, ledit au moins un premier paramètre pouvant être différent ou identique audit au moins un paramètre physico-chimique ;
   - estimer (43) ledit au moins un paramètre physico-chimique à partir d'une excitation électrique appartenant à une catégorie distincte de la première parmi lesdites au moins deux excitations de catégories différentes préalablement appliquées, du signal de réponse correspondant et dudit au moins un premier paramètre préalablement estimé ;
   - estimer (50) ledit état de santé du dispositif électrochimique comme écart entre la valeur préalablement estimée dudit au moins un paramètre physico-chimique et une valeur de référence prédéterminée.

2. Procédé selon la revendication 1, **caractérisé en ce que** ladite excitation électrique de première catégorie et ladite excitation électrique de catégorie distincte de la première catégorie sont appliquées de manière séquentielle.

3. Procédé selon la revendication 1, **caractérisé en ce qu'**au moins une excitation électrique de première catégorie est ladite séquence de perturbations sinusoïdales de courant ou de tension.

4. Procédé selon la revendication 2, **caractérisé en ce que** l'excitation électrique de première catégorie est un échelon de courant ou de tension, et **en ce que** l'excitation électrique de catégorie distincte est ladite séquence de perturbations sinusoïdales de courant ou de tension.

5. Procédé selon la revendication 3, **caractérisé en ce que** que ladite excitation électrique de catégorie distincte de la première est une variation de courant ou de tension allant de zéro à une valeur nominale.

6. Procédé selon l'une quelconque des revendications 1 à 5, **caractérisé en ce que** l'on estime (50) ledit état de santé, en outre, comme écart entre la valeur estimée dudit au moins un premier paramètre et une valeur de référence prédéterminée.

**7.** Procédé selon l'une quelconque des revendications 1 à 3, **caractérisé en ce que** ledit signal d'entrée comprend au moins trois excitations de catégories différentes, et

**en ce que**, préalablement à l'étape d'estimation (43) dudit au moins un paramètre physico-chimique, on estime (42) au moins un deuxième paramètre à partir d'une excitation électrique appartenant à une deuxième catégorie distincte de la première parmi lesdites au moins trois excitations de catégories différentes préalablement appliquées, du signal de réponse correspondant ;

l'estimation (43) dudit au moins un paramètre physico-chimique étant effectuée à partir d'une excitation électrique appartenant à une troisième catégorie distincte de la première et de la deuxième parmi lesdites au moins trois excitations de catégories différentes préalablement appliquées, du signal de réponse correspondant et dudit au moins un premier paramètre et dudit au moins un deuxième paramètre préalablement estimés.

**8.** Procédé selon la revendication 7, **caractérisé en ce que** ledit au moins un deuxième paramètre est estimé, en outre, à partir dudit au moins un premier paramètre préalablement estimé.

**9.** Procédé selon la revendication 7 ou 8, **caractérisé en ce que** l'excitation électrique de première catégorie est un échelon de courant ou de tension,

**en ce que** l'excitation électrique de deuxième catégorie est ladite séquence de perturbations sinusoïdales de courant ou de tension, et

**en ce que** l'excitation électrique de troisième catégorie est une variation de courant ou de tension allant de zéro à une valeur nominale.

**10.** Procédé selon l'une quelconque des revendications 7 à 9, **caractérisé en ce que** l'on estime (50) ledit état de santé comme, en outre, écart entre la valeur estimée dudit au moins un premier paramètre et une valeur de référence prédéterminée, et/ou comme écart entre la valeur estimée dudit au moins un second paramètre et une valeur de référence prédéterminée.

**11.** Procédé selon l'une quelconque des revendications précédentes, **caractérisé en ce que** chaque sous-suite de ladite pluralité est entrelacée avec toutes les autres sous-suites de la même pluralité.

**12.** Procédé selon la revendication 11, **caractérisé en ce que** les perturbations de ladite séquence sont appliquées de manière à balayer de manière monotone les fréquences de chaque sous-suite ($A_i$).

**13.** Procédé selon la revendication 11, **caractérisé en ce que** les perturbations de ladite séquence sont appliquées de manière à balayer de manière aléatoire les fréquences de chaque sous-suite ($A_i$).

**14.** Procédé selon l'une quelconque des revendications 11 à 13, **caractérisé en ce que** les sous-suites sont classées suivant un ordre déterminé, les perturbations de ladite séquence étant appliquées de manière à balayer de manière monotone lesdites sous-suites ($A_1,...,A_n$) de ladite pluralité.

**15.** Procédé selon l'une quelconque des revendications 11 à 14, **caractérisé en ce que**, les sous-suites sont classées suivant un ordre déterminé, les perturbations de ladite séquence étant appliquées de manière à balayer de manière aléatoire lesdites sous-suites ($A_1,...,A_n$) de ladite pluralité.

**16.** Procédé selon l'une quelconque des revendications 1 à 15, **caractérisé en ce que**, l'un desdits paramètres étant la résistance électrique interne dudit dispositif électrochimique, l'estimation dudit paramètre à partir d'un échelon de courant ou de tension, et du signal de réponse correspondant, consiste à :

- soustraire audit signal d'entrée et audit signal de réponse correspondant leur valeur respective précédant l'application de ladite excitation électrique, pour ainsi obtenir la variation de courant et la variation de tension ;
- calculer l'impédance instantanée en divisant ladite variation de tension par ladite variation de courant, et détecter un instant $t_1$, supérieur à l'instant $t_0$ d'application de ladite excitation électrique, pour lequel ladite impédance instantanée présente un minimum ;
- extrapoler ladite impédance instantanée à partir de l'instant $t_1$, et projeter ladite extrapolation à l'instant $t_0$, pour ainsi en déduire la valeur de la résistante électrique interne dudit dispositif électrochimique.

**17.** Procédé selon l'une quelconque des revendications 1 à 16, **caractérisé en ce qu'**une évolution expérimentale de la tension en fonction du courant étant obtenue à partir dudit signal d'entrée et dudit signal de réponse correspondant, une évolution modèle de la tension en fonction du courant étant paramétrée par au moins l'un desdits paramètres, l'estimation dudit paramètre à partir d'une variation de courant ou de tension allant de zéro à une valeur nominale est obtenue par :

la minimisation d'une grandeur caractéristique de l'écart existant entre, d'une part, ladite évolution modèle de la tension et de ses N dérivées successives, et d'autre part, ladite évolution expérimentale de la tension et de ses N dérivées successives.

18. Procédé selon l'une quelconque des revendications précédentes, **caractérisé en ce que** ledit dispositif électrochimique est une pile à combustible.

19. Procédé de commande d'un dispositif électrochimique, **caractérisé en ce qu'**il comporte :

- la détermination d'un état de santé selon l'une quelconque des revendications précédentes ; puis
- l'application d'une commande audit dispositif électrochimique lorsque ledit écart dépasse une valeur seuil prédéterminée.

**Patentansprüche**

1. Verfahren zu Bestimmung eines Gesundheitszustands einer elektrochemischen Vorrichtung vom Typ Brennstoffzelle ausgehend von wenigstens einem physikalisch-chemischen Parameter, der wenigstens teilweise das physikalisch-chemische Verhalten der elektrochemischen Vorrichtung modelliert, wobei das Verfahren **dadurch gekennzeichnet ist, dass** es die folgenden Schritte umfasst:

- Anlegen (10), an die elektrochemische Vorrichtung, eines Eingangssignals, das eine Mehrzahl von elektrischen Anregungen umfasst, wobei jede Anregung zu einer bestimmten Kategorie von Anregungen gehört, ausgewählt aus einer Gruppe, die gebildet ist durch eine Sequenz von sinusförmigen Strom- oder Spannungsstörungen um einen Polarisationspunkt der elektrochemischen Vorrichtung herum, wobei die Amplitude der Störungen kleiner als 10% eines Stromwerts an dem Polarisationspunkt ist, damit die Antwort der elektrochemischen Vorrichtung linear bleibt, wobei jede Störung eine verschiedene Frequenz hat, die zu einer Hauptfolge (A) von Frequenzen gehört, wobei die Sequenz von Störungen derart angelegt wird, dass Zug um Zug eine Mehrzahl von Unterfolgen $(A_1, ..., A_n)$ abgetastet wird, wobei jede der Unterfolgen $(A_1, ..., A_n)$ eine Gruppe von Frequenzen ist, die aus der Hauptfolge (A) stammen, wobei jede Unterfolge der Mehrzahl mit wenigstens einer anderen Unterfolge der gleichen Mehrzahl derart interlaced ist, dass sie wenigstens eine Frequenz umfasst, die zwischen zwei aufeinanderfolgenden Frequenzen der wenigstens einen Unterfolge enthalten ist, mit der sie interlaced ist; durch einen Strom- oder Spannungssprung; und durch eine Strom- oder Spannungsvariation, die von Null bis zu einem Nominalwert geht, wobei das Eingangssignal wenigstens zwei Anregungen von verschiedenen Kategorien umfasst, von denen wenigstens eine die Sequenz von sinusförmigen Strom- oder Spannungsstörungen ist, und Messen eines Ausgangssignals (20) der elektrochemischen Vorrichtung in Antwort auf das Eingangssignal; dann
- Extrahieren (30), ausgehend von dem Ausgangssignal, der Antwortsignale, die jeder von den elektrischen Anregungen zugeordnet sind; dann
- Abschätzen (41) wenigstens eines ersten Parameters ausgehend von einer elektrischen Anregung, die zu einer ersten Kategorie gehört, von den wenigstens zwei Anregungen von verschiedenen Kategorien, die zuvor angelegt wurden, und von dem entsprechenden Antwortsignal, wobei der wenigstens eine erste Parameter verschieden von oder identisch mit dem wenigstens einen physikalisch-chemischen Parameter sein kann;
- Abschätzen (43) des wenigstens einen physikalisch-chemischen Parameters ausgehend von einer elektrischen Anregung, die zu einer von der ersten verschiedenen Kategorie gehört, von den wenigstens zwei Anregungen von verschiedenen Kategorien, die zuvor angelegt wurden, von dem entsprechenden Antwortsignal und vom dem wenigstens einen zuvor abgeschätzten ersten Parameter;
- Abschätzen (50) des Gesundheitszustands der elektrochemischen Vorrichtung als Abstand zwischen dem zuvor abgeschätzten Wert des wenigstens einen physikalisch-chemischen Parameters und einem vorbestimmten Referenzwert.

2. Verfahren nach Anspruch 1, **dadurch gekennzeichnet, dass** die elektrische Anregung der ersten Kategorie und die elektrische Anregung der von der ersten Kategorie verschiedenen Kategorie in sequentieller Weise angelegt werden.

3. Verfahren nach Anspruch 1, **dadurch gekennzeichnet, dass** wenigstens eine elektrische Anregung der ersten Kategorie die Sequenz von sinusförmigen Strom- oder Spannungsstörungen ist.

4. Verfahren nach Anspruch 2, **dadurch gekennzeichnet, dass** die elektrische Anregung der ersten Kategorie ein Strom- oder Spannungssprung ist, und dass die elektrische Anregung der anderen Kategorie die Sequenz von sinusförmigen Strom- oder Spannungsstörungen ist.

5. Verfahren nach Anspruch 3, **dadurch gekennzeichnet, dass** die elektrische Anregung der von der ersten verschiedenen Kategorie eine Strom- oder Spannungsvariation ist, die von Null bis zu einem Nominalwert geht.

6. Verfahren nach einem der Ansprüche 1 bis 5, **dadurch gekennzeichnet, dass** man den Gesundheitszustand ferner als Abstand zwischen dem geschätzten Wert des wenigstens einen ersten Parameters und einem vorbestimmten Referenzwert abschätzt (50).

7. Verfahren nach einem der Ansprüche 1 bis 3, **dadurch gekennzeichnet, dass** das Eingangssignal wenigstens drei Anregungen von verschiedenen Kategorien umfasst, und
dass man vor dem Schritt des Abschätzens (43) des wenigstens einen physikalisch-chemischen Parameters wenigstens einen zweiten Parameter abschätzt (42) ausgehend von einer elektrischen Anregung, die zu einer von der ersten verschiedenen zweiten Kategorie gehört, von den wenigstens drei Anregungen von verschiedenen Kategorien, die zuvor angelegt wurden, von dem entsprechenden Antwortsignal;
wobei die Abschätzung (43) des wenigstens einen physikalisch-chemischen Parameters durchgeführt wird ausgehend von einer elektrischen Anregung, die zu einer von der ersten und von der zweiten verschiedenen dritten Kategorie gehört, von den wenigstens drei Anregungen von verschiedenen Kategorien, die zuvor angelegt wurden, von dem entsprechenden Antwortsignal und von dem wenigstens einen ersten Parameter und von dem wenigstens einen zweiten Parameter, die zuvor abgeschätzt wurden.

8. Verfahren nach Anspruch 7, **dadurch gekennzeichnet, dass** der wenigstens eine zweite Parameter ferner ausgehend von dem wenigstens einen ersten Parameter abgeschätzt wird, der zuvor abgeschätzt wurde.

9. Verfahren nach Anspruch 7 oder 8, **dadurch gekennzeichnet, dass** die elektrische Anregung der ersten Kategorie ein Strom- oder Spannungssprung ist,
dass die elektrische Anregung der zweiten Kategorie die Sequenz von sinusförmigen Strom- oder Spannungsstörungen ist, und
dass die elektrische Anregung der dritten Kategorie eine Strom- oder Spannungsvariation ist, die von Null bis zu einem Nominalwert geht.

10. Verfahren nach einem der Ansrpüche 7 bis 9, **dadurch gekennzeichnet, dass** man den Gesundheitszustand ferner als Abstand zwischen dem abgeschätzten Wert des wenigstens einen ersten Parameters und einem vorbestimmten Referenzwert bestimmt (50), und/oder als Abstand zwischen dem abgeschätzten Wert des wenigstens einen zweiten Parameters und einem vorbestimmten Referenzwert.

11. Verfahren nach einem der vorhergehenden Ansprüche, **dadurch gekennzeichnet, dass** jede Unterfolge der Mehrzahl mit allen anderen Unterfolgen der gleichen Mehrzahl interlaced ist.

12. Verfahren nach Anspruch 11, **dadurch gekennzeichnet, dass** die Störungen der Sequenz derart angelegt werden, dass die Frequenzen jeder Unterfolge ($A^i$) auf monotone Weise abgetastet werden.

13. Verfahren nach Anspruch 11, **dadurch gekennzeichnet, dass** die Störungen der Sequenz derart angelegt werden, dass die Frequenzen jeder Unterfolge ($A^i$) auf zufällige Weise abgetastet werden.

14. Verfahren nach einem der Ansprüche 11 bis 13, **dadurch gekennzeichnet, dass** die Unterfolgen gemäß einer vorbestimmten Reihenfolge klassifiziert werden, wobei die Störungen der Sequenz derart angelegt werden, dass die Unterfolgen ($A_1$, ..., $A_n$) der Mehrzahl auf monotone Weise abgetastet werden.

15. Verfahren nach einem der Ansprüche 11 bis 14, **dadurch gekennzeichnet, dass** die Unterfolgen gemäß einer vorbestimmten Reihenfolge klassifiziert werden, wobei die Störungen der Sequenz derart angelegt werden, dass die Unterfolgen ($A_1$, ..., $A_n$) der Mehrzahl auf zufällige Weise abgetastet werden.

16. Verfahren nach einem der Ansprüche 1 bis 15, **dadurch gekennzeichnet, dass** dann, wenn der eine der Parameter der elektrische Innenwiderstand der elektrochemischen Vorrichtung ist, die Abschätzung des Parameters ausgehend von einem Strom- oder Spannungssprung und von dem entsprechenden Antwortsignal aus Folgenden besteht:

- Subtrahieren, von dem Eingangssignal und von dem entsprechenden Antwortsignal, ihres jeweiligen Werts, der dem Anlegen der elektrischen Anregung vorhergeht, um somit die Stromvariation und die Spannungsvariation zu erhalten;
- Berechnen der instantanen Impedanz durch Dividieren der Spannungsvariation durch die Stromvariation, und Detektieren eines Zeitpunkts $t_1$ größer als der Zeitpunkt $t_0$ des Anlegens der elektrischen Anregung, für den die instantane Impedanz ein Minimum aufweist;
- Extrapolieren der instantanen Impedanz ausgehend von dem Zeitpunkt $t_1$ und Projezieren der Extrapolation auf den Zeitpunkt $t_0$, um somit hieraus den Wert des elektrischen Innenwiderstands der elektrochemischen Vorrichtung abzuleiten.

17. Verfahren nach einem der Ansprüche 1 bis 16, **dadurch gekennzeichnet, dass** eine experimentelle Entwicklung der Spannung als Funktion des Stroms erhalten wird ausgehend von dem Eingangssignal und von dem entsprechenden Antwortsignal, wobei eine Modellentwicklung der Spannung als Funktion des Stroms mittels wenigstens eines der Parameter parametrisiert wird, wobei die Abschätzung des Parameters ausgehend von einer Strom- oder Spannungsvariation von Null bis zu einem Nominalwert geht und erhalten wird durch:
die Minimierung einer charakteristischen Größe des Abstands, der einerseits zwischen der Modellentwicklung der Spannung und ihren N aufeinanderfolgenden Ableitungen existiert, und andererseits zwischen der experimentellen Entwicklung der Spannung und ihren N aufeinanderfolgenden Ableitungen.

18. Verfahren nach einem der vorhergehenden Ansrüche, **dadurch gekennzeichnet, dass** die elektrochemische Vorrichtung eine Brennstoffzelle ist.

19. Verfahren zur Steuerung einer elektroschemischen Vorrichtung, **dadurch gekennzeichnet, dass** es umfasst:

- die Bestimmung eines Gesundheitszustands gemäß einem der vorhergehenden Ansprüche; dann
- das Anlegen eines Steuerungsbefehls an die elektrochemische Vorrichtung, wenn der Abstand einen vorbestimmten Schwellenwert übersteigt.

**Claims**

1. A method for determining a state of health of an electrochemical device, of the fuel cell type, from at least one physico-chemical parameter modelling at least partly the physico-chemical behaviour of said electrochemical device, said method being **characterised in that** it includes the following steps of:

- applying (10) to said electrochemical device an input signal comprising a plurality of electric excitations, each excitation belonging to a determined excitation category selected from a set formed by a sequence of current or voltage sinusoidal disturbances, about a bias point of said electrochemical device, the amplitude of disturbances being lower than 10% of a value of current at said bias point such that the response of the electrochemical device remains linear, each disturbance having a different frequency belonging to a main progression (A) of frequencies, said sequence of disturbances being applied so as to alternately scan a plurality of sub-progressions $(A_1, ..., A_n)$, each of said sub-progressions $(A_1, ..., A_n)$ being a set of frequencies from the main progression (A), each sub-progression of said plurality being interleaved with at least one other sub-progression of the same plurality so that it includes at least one frequency included between two consecutive frequencies of said at least one sub-progression with which it is interleaved; a current or voltage step; and a current or voltage variation ranging from zero to a nominal value, said input signal comprising at least two excitations of different categories at least one of which being said sequence of current or voltage sinusoidal disturbances, and measuring an output signal (20) of said electrochemical device in response to said input signal; and then
- extracting (30), from said output signal, the response signals associated with each of said electric excitations; and then
- estimating (41) at least one first parameter from an electric excitation belonging to a first category from said at least two excitations of different categories previously applied, and from the corresponding response signal, wherein said at least one first parameter can be different from or identical to said at least one physico-chemical parameter;
- estimating (43) said at least one physico-chemical parameter from an electric excitation belonging to a category distinct from the first from said at least two excitations of different categories previously applied, from the corresponding response signal and from said at least one first parameter previously estimated;
- estimating (50) said state of health of the electrochemical device as a deviation between the value previously estimated of said at least one physico-chemical parameter and a predetermined reference value.

2.  The method according to claim 1, **characterised in that** said electric excitation of a first category and said electric excitation of a category distinct from the first category are sequentially applied.

3.  The method according to claim 1, **characterised in that** at least one electric excitation of a first category is said sequence of current or voltage sinusoidal disturbances.

4.  The method according to claim 2, **characterised in that** the electric excitation of a first category is a current or voltage step, and **in that** the electric excitation of a distinct category is said sequence of current or voltage sinusoidal disturbances.

5.  The method according to claim 3, **characterised in that** said electric excitation of a category distinct from the first one is a current or voltage variation ranging from zero to a nominal value.

6.  The method according to any of claims 1 to 5, **characterised in that** said state of health is further estimated (50), as a deviation between the estimated value of said at least one first parameter and a predetermined reference value.

7.  The method according to any of claims 1 to 3, **characterised in that** said input signal comprises at least three excitations of different categories, and
    **in that**, prior to the step of estimating (43) said at least one physico-chemical parameter, at least one second parameter is estimated (42) from an electric excitation belonging to a second category distinct from the first one from said at least three excitations of different categories previously applied, from the corresponding response signal; estimating (43) said at least one physico-chemical parameter being performed from an electric excitation belonging to a third category distinct from the first and from the second one from said at least three excitations of different categories previously applied, from the corresponding response signal and from said at least one first parameter and said at least one second parameter previously estimated.

8.  The method according to claim 7, **characterised in that** said at least one second parameter is further estimated, from said at least one first parameter previously estimated.

9.  The method according to claim 7 or 8, **characterised in that** the electric excitation of a first category is a current or voltage step,
    **in that** the electric excitation of the second category is said sequence of current or voltage sinusoidal disturbances, and
    **in that** the electric excitation of the third category is a current or voltage variation ranging from zero to a nominal value.

10. The method according to any of claims 7 to 9, **characterised in that** said state of health is further estimated (50) as a deviation between the estimated value of said at least one first parameter and a predetermined reference value, and/or as a deviation between the estimated value of said at least one second parameter and a predetermined reference value.

11. The method according to any of the previous claims, **characterised in that** each sub-progression of said plurality is interleaved with all the other sub-progressions of the same plurality.

12. The method according to claim 11, **characterised in that** the disturbances of said sequence are applied so as to monotonously scan the frequencies of each sub-progression ($A_i$),

13. The method according to claim 11, **characterised in that** the disturbances of said sequence are applied so as to randomly scan the frequencies of each sub-progression ($A_i$),

14. The method according to any of claims 11 to 13, **characterised in that** the sub-progressions are classified according to a determined order, the disturbances of said sequence being applied so as to monotonously scan said sub-progressions ($A_1$, ..., $A_n$) of said plurality.

**15.** The method according to any of claims 11 to 14, **characterised in that**, the sub-progressions are classified according to a determined order, the disturbances of said sequence being applied so as to randomly scan said sub-progressions $(A_1, ..., A_n)$ of said plurality.

**16.** The method according to any of claims 1 to 15, **characterised in that**, one of said parameter being the internal electric resistance of said electrochemical device, estimating said parameter from a current or voltage step, and from the corresponding response signal, consists in:

- subtracting from said input signal and from said corresponding response signal their respective value prior to applying said electric excitation, to thus obtain the current variation and voltage variation;
- calculating the instantaneous impedance by dividing said voltage variation by said current variation, and detecting a time instant $t_1$, greater than time instant $t_0$ for applying said electric excitation, for which said instantaneous impedance has a minimum;
- extrapolating said instantaneous impedance from time instant $t_1$, and projecting said extrapolation at instant $t_0$, to thus derive the value of the internal electric resistance of said electrochemical device.

**17.** The method according to any of claims 1 to 16, **characterised in that** an experimental variation in the voltage as a function of the current being obtained from said input signal and from said corresponding response signal, a model variation in the voltage as a function of the current being parameterised by at least one of said parameters, estimating said parameter from a current or voltage variation ranging from zero to a nominal value is obtained by: minimising a characteristic quantity of the deviation existing between, on the one hand, said model variation in the voltage and its N successive derivatives, and on the other hand, said experimental variation in the voltage and its N successive derivatives.

**18.** The method according to any of the previous claims, **characterised in that** said electrochemical device is a fuel cell.

**19.** A method for controlling an electrochemical device, **characterised in that** it includes:

- determining a state of health according to any of the previous claims; and then
- applying control to said electrochemical device when said deviation exceeds a predetermined threshold value.

# FIG. 1

Application de E(t) combinant
plusieurs excitations électriques $e_i(t)$ — 10

Mesure de S(t) — 20

Extraction, à partir de S(t),
des réponses $s_i(t)$ aux différentes excitations — 30

41 — Estimation
d'au moins un premier paramètre
à partir d'une excitation
d'une première catégorie

Estimation
d'au moins un paramètre physico-chimique
à partir d'une excitation
de catégorie distincte de la première — 42

SOH comme écart valeur estimée / valeur de référence — 50

FIG. 2A

FIG. 2B

FIG. 3

FIG. 4

```
                    ┌─────────────────────────────┐  ⟋ 10
                    │   Application de E(t) combinant │
                    │ plusieurs excitations électriques e_i(t) │
                    └─────────────────────────────┘
                                  │
                                  ▼
                         ┌──────────────┐  ⟋ 20
                         │ Mesure de S(t) │
                         └──────────────┘
                                  │
                                  ▼
              ┌──────────────────────────────────┐  ⟋ 30
              │      Extraction, à partir de S(t),    │
              │ des réponses s_i(t) aux différentes excitations │
              └──────────────────────────────────┘
```

41    42

```
┌────────────────────────┐        ┌────────────────────────┐
│       Estimation        │        │       Estimation        │
│ d'au moins un premier paramètre │ │ d'au moins un deuxième paramètre │
│    à partir d'une excitation    │ │    à partir d'une excitation    │
│   d'une première catégorie      │ │   d'une deuxième catégorie      │
└────────────────────────┘        └────────────────────────┘

            ┌────────────────────────────────────┐  ⟋ 43
            │           Estimation                │
            │ d'au moins un paramètre physico-chimique │
            │       à partir d'une excitation         │
            │      d'une troisième catégorie          │
            └────────────────────────────────────┘

┌──────────────────────────────────────────────┐  ⟋ 50
│  SOH comme écart valeur estimée / valeur de référence │
└──────────────────────────────────────────────┘
```

# FIG. 5

FIG. 6

Application de E(t) combinant
plusieurs excitations électriques $e_i$(t) — 10

Mesure de S(t) — 20

Extraction, à partir de S(t),
des réponses $s_i$(t) aux différentes excitations — 30

41

Estimation d'au moins
un premier paramètre à partir d'une
excitation d'une première catégorie

Estimation d'au moins
un deuxième paramètre à partir d'une
excitation d'une deuxième catégorie — 42  43

Estimation d'au moins
un paramètre physico-chimique à partir
d'une excitation d'une troisième
catégorie

SOH comme écart valeur estimée / valeur de référence — 50

FIG. 7

FIG. 8A

FIG. 8B

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **FOUQUET et al.** Model based PEM fuel cell state-of-health monitoring via ac impedance measurements. *Journal of Power Sources,* 2006, vol. 159, 905-913
- Modélisation et caractérisation de la pile PEM pour l'étude des interactions avec les convertisseurs statiques. Institut National Polytechnique de Toulouse, 2005
- **CHO et al.** Transient response of a unit proton-exchange membrane fuel cell under various operating conditions. *Journal of Power Sources,* 2008, vol. 185, 118-128